# EUROPÄISCHE PATENTSCHRIFT

(11) **EP 3 721 558 B1**
(45) Veröffentlichungstag und Bekanntmachung des Hinweises auf die Patenterteilung: **27.03.2024**
(21) Anmeldenummer: 18816003.0
(22) Anmeldetag: 06.12.2018
(51) Int. Cl.: H03K 17/96, H03K 17/94, H03K 17/082, H03K 17/042, H05K 1/02, H05K 1/18

(54) **SCHALTBEDIENFELD**
SWITCH CONTROL PANEL
PANNEAU DE COMMANDE DE COMMUTATION

(30) Priorität: 07.12.2017 DE 102017011274
(43) Veröffentlichungstag der Anmeldung: 14.10.2020
(73) Patentinhaber: Marquardt GmbH, 78604 Rietheim-Weilheim (DE)
(72) Erfinder: BAUER, Lutz, 78604 Rietheim-Weilheim (DE); NEITZEL, Roland, 78570 Mülheim a. d. Donau (DE); HAGGE, Robert, 78073 Bad Dürrheim (DE); GREABU, Liliana, 55018 Sibiu (RO)
(74) Vertreter: Staeger & Sperling Partnerschaftsgesellschaft mbB
(86) Internationale Anmeldenummer: PCT/EP2018/083719
(87) Internationale Veröffentlichungsnummer: WO 2019/110701

(56) Entgegenhaltungen:
- DE-A1-102011 119 137
- DE-U1-202013 100 760
- DE-U1-202016 101 317
- US-A1- 2012 320 385
- US-A1- 2014 213 323
- US-A1- 2014 368 029

## Beschreibung

Die Erfindung betrifft ein Schaltbedienfeld nach dem Oberbegriff des Patentanspruchs 1. Solche Schaltbedienfelder werden in Kraftfahrzeugen zur Bedienung unterschiedlichster Funktionen durch einen Benutzer eingesetzt. Beispielsweise kann das Schaltbedienfeld im Lenkrad, im Armaturenbrett, in der Mittelkonsole, in einer Armablage o. dgl. im Kraftfahrzeug eingesetzt werden.

Ein derartiges Schaltbedienfeld weist eine Betätigungsfläche für die manuelle Einwirkung mittels eines Elements durch den Benutzer auf. Insbesondere kann es sich bei dem Element um den Finger einer menschlichen Hand handeln, mit dessen Hilfe die Betätigung des Schaltbedienfeldes erfolgt. Die Betätigungsfläche wirkt dabei mit einem Sensor derart zusammen, dass der Sensor bei Annäherung des Elements an die Betätigungsfläche und/oder bei Berührung der Betätigungsfläche mittels des Elements und/oder bei Druckeinwirkung mittels des Elements auf die Betätigungsfläche ein Signal erzeugt. Das Signal dient zum Schalten und/oder Auslösen einer Funktion im Kraftfahrzeug in der Art eines Schalt- und/oder Steuersignals.

Bei dem Sensor handelt es sich um einen mit optischer elektromagnetischer Strahlung arbeitenden Sensor . Es hat sich herausgestellt, dass in manchen Fällen Ungenauigkeiten bei der Bedienung eines solchen, mit einem optischen Sensor ausgestatteten Schaltbedienfeldes auftreten, wobei der Bedienungswunsch des Benutzers nicht richtig oder gar nicht erkannt wird.

Die US 2014/368029 A1 offenbart ein Schaltbedienfeld nach dem Oberbegriff des Patentanspruchs 1.

Der Erfindung liegt die Aufgabe zugrunde, das Schaltbedienfeld derart weiterzuentwickeln, dass die Genauigkeit der Bedienung verbessert ist.

Diese Aufgabe wird bei einem gattungsgemäßen Schaltbedienfeld durch die kennzeichnenden Merkmale des Anspruchs 1 gelöst.

Beim erfindungsgemäßen Schaltbedienfeld wirkt der optische Sensor mit einer Linse zusammen, derart dass die vom Sensor ausgesandte Strahlung und/oder die vom Sensor empfangene Strahlung zum und/oder vom Element ausgerichtet ist. In vorteilhafter Weise ist die optische Strahlung daher an die jeweilige Gestaltung des Schaltbedienfeldes anpassbar. Insbesondere lässt sich die optische Strahlung auf das der Bedienung dienende Element und/oder auf den Bereich, in dem die Bedienbarkeit gewünscht ist, fokussieren, womit eine präzise Bedienung des Schaltbedienfeldes durch den Benutzer gewährleistet ist.

Beim erfindungsgemäßen Schaltbedienfeld weist das Schaltbedienfeld wiederum eine Betätigungsfläche für die manuelle Einwirkung mittels eines Elements durch den Benutzer auf. Insbesondere kann es sich bei dem Element um den Finger einer menschlichen Hand handeln, mit dessen Hilfe die Betätigung des Schaltbedienfeldes erfolgt. Mit der Betätigungsfläche wirken hier zwei Sensoren derart zusammen, dass der jeweilige Sensor bei Annäherung des Elements an die Betätigungsfläche und/oder bei Berührung der Betätigungsfläche mittels des Elements und/oder bei Druckeinwirkung mittels des Elements auf die Betätigungsfläche ein Signal erzeugt, wobei das Signal zum Schalten und/oder Auslösen einer dem jeweiligen Sensor zugeordneten Funktion im Kraftfahrzeug in der Art eines Schalt- und/oder Steuersignals dient.

Bei dem ersten Sensor handelt es sich um einen kapazitiv arbeitenden Sensor und bei dem zweiten Sensor um einen mit optischer elektromagnetischer Strahlung arbeitenden Sensor. Erfindungsgemäß wirkt der optische Sensor mit einer Linse zusammen, derart dass die vom Sensor ausgesandte Strahlung und/oder die vom Sensor empfangene Strahlung zum und/oder vom Element ausgerichtet ist, insbesondere auf das der Bedienung dienende Element und/oder auf den Bereich, in dem die Bedienbarkeit gewünscht ist, fokussiert ist.

Dadurch lässt sich die optische Strahlung in einfacher Art und Weise an die jeweilige Gestaltung des Schaltbedienfeldes anpassen, womit die präzisiere Bedienbarkeit des Schaltbedienfeldes sichergestellt ist.

Weitere Ausgestaltungen der Erfindung sind Gegenstand der Unteransprüche.

Erfindungsgemäß weist der kapazitive Sensor eine elektrisch leitfähige Folie auf. Die elektrisch leitfähige Folie ist in und/oder an der Betätigungsfläche angeordnet, derart dass durch Anlegen einer elektrischen Spannung ein elektrisches Feld im Bereich der Betätigungsfläche erzeugbar ist. In einfacher Art und Weise kann die durch die Einwirkung des Elements auf die Betätigungsfläche hervorgerufene Veränderung des elektrischen Feldes, und zwar insbesondere dessen kapazitive Veränderung, zur Erzeugung des Signals ausgewertet werden. Ein solches Schaltbedienfeld zeichnet sich auch durch besondere Kostengünstigkeit aus.

In funktionssicherer Ausgestaltung kann der optische Sensor einen optischen Sender und wenigstens einen optischen Empfänger für die optische elektromagnetische Strahlung umfassen, derart dass der optische Sensor reflexionsoptisch zur Erzeugung des Signals arbeitet. Zweckmäßigerweise kann es sich bei dem optischen Sender um eine Leuchtdiode, eine IR(Infrarot)-Diode, eine Laserdiode o. dgl. handeln. Bei dem optischen Empfänger kann es sich um eine Fotodiode handeln.

Zum Schutz vor äußeren, schädlichen Einflüssen weist erfindungsgemäß das Schaltbedienfeld ein Gehäuse zur Aufnahme der Betätigungsfläche auf. Insbesondere kann dabei die Betätigungsfläche eine im Wesentlichen geschlossene Oberfläche am Gehäuse bilden. Das Schaltbedienfeld lässt sich dadurch auch unter rauen Umgebungsbedingungen einsetzen. Die Betätigungsfläche ist Bestandteil einer Blende, insbesondere in der Art einer Sichtblende, womit das Schaltbedienfeld in einfacher Art und Weise im Kraftfahrzeug eingebaut werden kann. In funktionssicherer sowie kompakter Art kann die elektrisch leitfähige Folie durch Kleben an der Blende, durch Umspritzen und/oder Hinterspritzen mittels der Blende o. dgl. befestigt sein. Zweckmäßigerweise ist die Befestigung der elektrisch leitfähigen Folie an der dem Inneren des Gehäuses zugewandten Seite der Blende vorgenommen , so dass die elektrisch leitfähige Folie vor Beschädigungen wirksam geschützt ist. Zur Verbesserung der Haptik für den Benutzer bietet die Blende einen mechanischen Hub für die Betätigungsfläche, wozu die Blende bewegbar am Gehäuse angeordnet ist. In einem solchen Fall hat der Benutzer bei dessen Einwirken auf die Betätigungsfläche das gewohnte Schaltgefühl eines herkömmlichen elektrischen Schalters.

Zweckmäßigerweise kann die Blende für die optische elektromagnetische Strahlung im Wesentlichen transparent ausgebildet sein. Der guten Funktionssicherheit halber kann die elektrisch leitfähige Folie im Bereich des optischen Sensors eine Aussparung und/oder eine Freisparung besitzen und/oder für die optische elektromagnetische Strahlung im Wesentlichen transparent ausgebildet sein. Zwecks besonders störungssicherer Bedienbarkeit kann es sich bei der optischen elektromagnetischen Strahlung um Infrarotstrahlung handeln. Zweckmäßigerweise kann dann die Blende für Infrarotstrahlung im Wesentlichen durchlässig sowie für optische elektromagnetische Strahlung in dem für das menschliche Auge sichtbaren Spektrum im Wesentlichen undurchlässig ausgebildet sein. Dadurch ist das Innere des Gehäuses für das menschliche Auge nicht sichtbar und die Blende kann in einfacher Art und Weise dem Design der Teile, die das Schaltbedienfeld aufnehmen, angepasst sein.

Des Weiteren können der Sensor sowie die Linse der Blende zugewandt im Gehäuse angeordnet sein. Zweckmäßigerweise kann die Linse zwischen dem Sensor und der Blende angeordnet sein. Dadurch lässt sich eine besonders kompakte Gestaltung des Schaltbedienfeldes erzielen, indem der Sensor sowie die Linse direkt unterhalb der geschlossenen und/oder individuell im Design gestalteten Sichtblende angebracht werden können. Es können der Sensor und die Linse als ein separates Bauteil ausgebildet sein. Zwecks weiterer Kompaktheit können der optische Sensor und die Linse jedoch auch als ein Verbund-Bauteil ausgestaltet sein.

In fertigungstechnisch einfacher Art und Weise ist der optische Sensor auf die elektrische leitfähige, kapazitive Folie gelötet und der optische Sensor sowie die Linse können an einem Träger befestigt angeordnet sein. Zweckmäßigerweise kann der Träger wiederum im Gehäuse befindlich sein.

In einer weiteren Ausgestaltung, die sich durch besondere fertigungstechnische Einfachheit sowie auch Kompaktheit auszeichnet, kann die elektrisch leitfähige, kapazitive Folie einen in etwa U-förmigen Einschnitt aufweisen. Dadurch kann ein absatzförmiger Bereich an der kapazitiven Folie ausgebildet sein, der Raum zur Aufnahme des optischen Sensors und/oder der Linse bereitstellt, so dass der optische Sensor am absatzförmigen Bereich an der kapazitiven Folie befestigt werden kann. In einfacher Art und Weise kann der optische Sensor auf die kapazitive Folie aufgelötet sein. Zweckmäßigerweise kann der absatzförmige Bereich mittels eines Trägerbauteils im Gehäuse abgestützt sein.

In einer bevorzugten Ausgestaltung des Schaltbedienfelds kann die kapazitive Folie wenigstens einen als ein Bedienschaltelement wirkenden Flächenbereich aufweisen. Der Flächenbereich dient dann zur Eingabe durch den Benutzer in der Art eines Push-Push-Schaltelements. Des Weiteren kann der optische Sensor als ein in mehrere Richtungen sensitives Schaltelement in der Art eines Navigationssensors arbeiten. Der optische Sensor dient dann zur Eingabe durch den Benutzer in der Art eines Multifunktionsschalters und/oder eines Touchpads. Beispielsweise kann dann mittels des optischen Sensors eine Cursor-Steuerung auf einem Bildschirm erfolgen. Ein solches Schaltbedienfeld eignet sich insbesondere als Schaltbedieneinheit für das Lenkrad in einem Kraftfahrzeug.

Für eine besonders bevorzugte Ausgestaltung des erfindungsgemäßen Schaltbedienfeldes ist nachfolgendes festzustellen.

Es ist ein optischer Sensor, der auf Infrarot-Basis arbeiten kann sowie mit einem Laser ausgestattet sein kann, und einer dementsprechenden separaten Linse auf eine kapazitive Folie gelötet. Mit Hilfe der auf die Anforderungen angepassten Linse können das Signal fokussiert und damit die Sensoreigenschaften unterstützt werden. Geschaffen ist dadurch ein Bedienfeld mit einer kapazitiven Folie und einem integriertem optischen Fingernavigationsensor in der Art einer Pad-Funktion. Die Folie mit dem optischen Sensor sowie der Linse sind dann direkt unterhalb einer geschlossenen und/oder individuell im Design gestalteten Sichtblende angebracht. Dadurch kann der optische Fingernavigationsensor in Verbindung mit der Linse sehr nah unterhalb der komplett individuell geschlossenen Bedienoberfläche angebracht werden. Die Position des Sensors mit der Linse wird bevorzugterweise durch Unterstützung mittels eines mechanischen Bauteils gewährleistet. Das mit einer komplett geschlossenen Oberfläche versehene Bedienfeld eignet sich beispielsweise zur Anordnung im Lenkrad eines Kraftfahrzeugs. Ein solcher Lenkradschalter bietet eine voll integrierte optische Fingernavigationssensorlösung, welche die Bewegungen des Fingers durch die geschlossene, einheitliche und/oder individuell gestaltete Bedienoberfläche erkennt und als Signal weitergeben kann.

Die mit der Erfindung erzielten Vorteile bestehen insbesondere darin, dass eine verbesserte Auflösung und/oder Fingererkennbarkeit hinsichtlich der Fingerbewegung zur Bedienung des Schaltbedienfeldes gewährleistet ist. Weiterhin lässt sich eine beliebige, komplett geschlossene Oberfläche für die Sichtblende herstellen. Des Weiteren lässt sich durch die kompakte Bauweise mehr Platz auf der Leiterplatte, die die Elektronik für das Schaltbedienfeld aufnimmt, schaffen. Zusätzlich kann der Einbauraum im Kraftfahrzeug verkleinert werden, so dass bei den gegebenen Gesamtabmaßen des Schaltbedienfeldes die möglichen Maximalmaße verkleinert werden können. Weiterhin ist vorteilhaft, dass der Sensor und die Linse sowohl als Verbundbauteil in der Art eines Package als auch separat verwendet werden können. Der Sensor sowie die Linse können somit individuell auf die gewünschten Anforderungen des Kunden beziehungsweise auf die Anforderungen des jeweiligen Schaltbedienfeldes angepasst werden.

Ausführungsbeispiele der Erfindung mit verschiedenen Weiterbildungen und Ausgestaltungen sind in den Zeichnungen dargestellt und werden im folgenden näher beschrieben. Es zeigen
- Fig. 1: ein Schaltbedienfeld in schematischer Ansicht sowie in Draufsicht,
- Fig. 2: einen Schnitt entlang der Linie 2-2 in Fig. 1,
- Fig. 3: ein Einzelteil aus Fig. 2 in Draufsicht,
- Fig. 4: einen Detailausschnitt aus Fig. 2 gemäß einem Schnitt entlang der Linie 4-4 in Fig. 3 und
- Fig. 5: eine schematische Ansicht entsprechend der Fig. 2 zur Betätigung des Schaltbedienfeldes durch einen Benutzer.

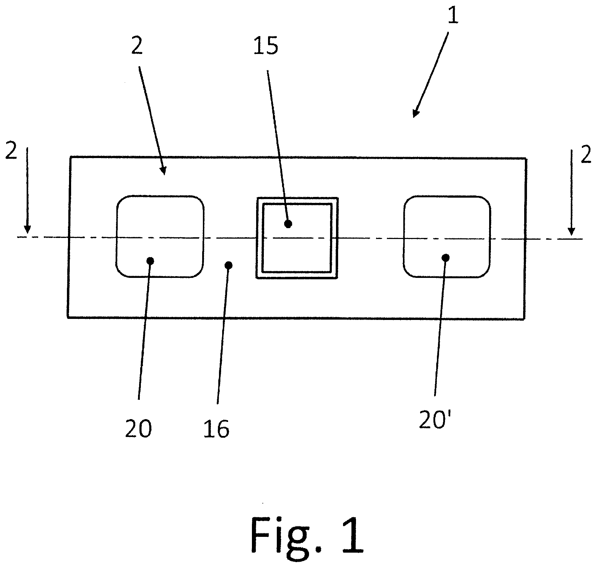

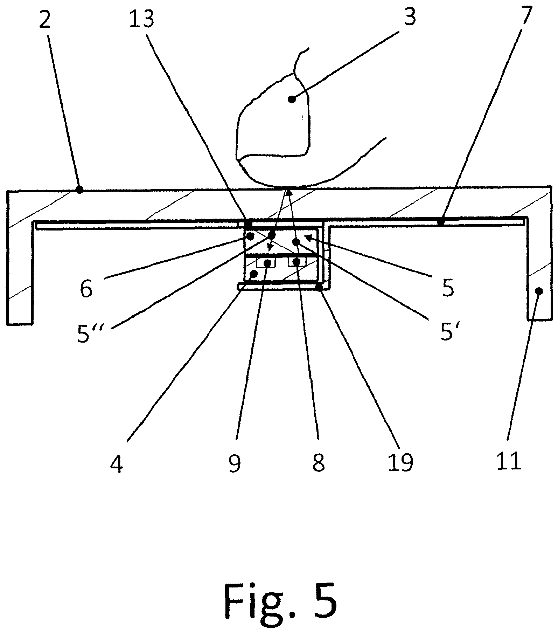

In Fig. 1 ist ein Schaltbedienfeld 1 für ein Kraftfahrzeug in schematischer Art in Draufsicht zu sehen. Das Schaltbedienfeld 1 besitzt eine Betätigungsfläche 2 zur manuellen Einwirkung mittels eines in Fig. 5 gezeigten Elements 3. Wie der Fig. 5 zu entnehmen ist, handelt es sich bei dem Element 3 insbesondere um den Finger einer menschlichen Hand. Selbstverständlich kann als Element 3 auch ein Stift o. dgl. für die Eingabe Verwendung finden. Mit der Betätigungsfläche 2 wirkt ein Sensor 4 derart zusammen, dass der Sensor 4 bei Annäherung des Elements 3 an die Betätigungsfläche 2 und/oder bei Berührung der Betätigungsfläche 2 mittels des Elements 3 und/oder bei Druckeinwirkung mittels des Elements 3 auf die Betätigungsfläche 2 ein Signal erzeugt. Das Signal dient dann zum Schalten und/oder Auslösen einer Funktion des Kraftfahrzeugs in der Art eines Schalt- und/oder Steuersignals. Beispielsweise kann das Signal zur Bedienung des Navigationsgeräts, des Autoradios, einer Klimaanlage o. dgl. im Kraftfahrzeug dienen.

Bei dem Sensor 4 handelt es sich um einen mit optischer elektromagnetischer Strahlung 5 arbeitenden Sensor. Hierzu wird elektromagnetische Strahlung 5' vom Sensor 4 emittiert. Wenigstens ein Teil der emittierten Strahlung 5' wird vom Element 3 reflektiert. Die reflektierte Strahlung 5" wird wiederum vom Sensor 4 detektiert und im Hinblick auf das Signal dann ausgewertet. Mit dem optischen Sensor 4 wirkt eine Linse 6 zusammen, derart dass die vom Sensor 4 ausgesandte Strahlung 5' und/oder die vom Sensor 4 empfangene Strahlung 5" zum und/oder vom Element 3 anpassbar ausgerichtet ist. Insbesondere fokussiert die Linse 6 die optische Strahlung 5 auf das Element 3 und/oder auf den für das Element 3 zur Bedienung vorgesehenen Bereich der Betätigungsfläche 2. Mit Hilfe der Linse 6 wird somit ein präziseres Signal ermöglicht, was wiederum für die Genauigkeit der Bedienung des Schaltbedienfeldes 1 förderlich ist.

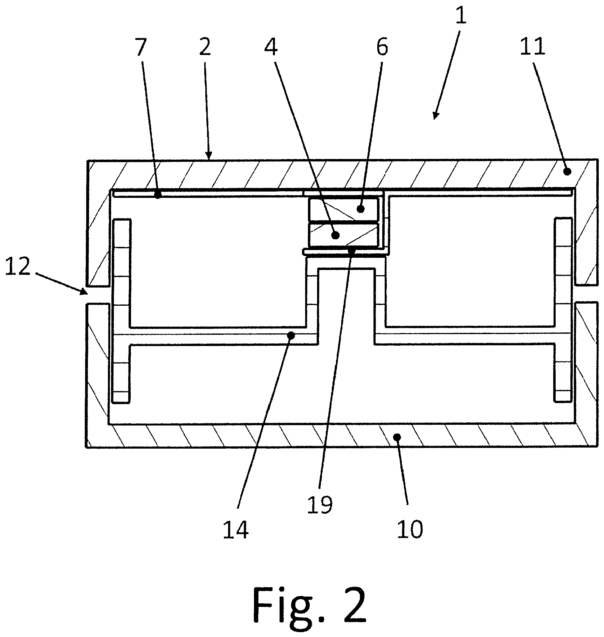

In einer weiteren Ausführung, die in Fig. 1 und Fig. 2 näher gezeigt ist, ist ein Schaltbedienfeld 1 zu sehen, das mit zwei, mit der Betätigungsfläche 2 zusammenwirkenden Sensoren arbeitet. Und zwar handelt es sich bei dem ersten Sensor um einen kapazitiv arbeitenden Sensor 7, der in einem ersten Bereich 16 der Betätigungsfläche 2 wirksam ist, und bei dem zweiten Sensor um einen mit optischer elektromagnetischer Strahlung 5 arbeitenden optischen Sensor 4, der in einem zweiten Bereich 15 der Betätigungsfläche 2 wirksam ist. Auch hier wirkt der optische Sensor 4 mit einer Linse 6 derart zusammen, dass die vom Sensor 4 ausgesandte Strahlung 5' und/oder die vom Sensor 4 empfangene Strahlung 5" zum und/oder vom Element 3 ausgerichtet, und zwar insbesondere fokussiert, ist. Aufgrund der manuellen Einwirkung mittels eines Elements 3, beispielsweise eines menschlichen Fingers, auf die Betätigungsfläche 2 bei Annäherung des Elements 3 an die Betätigungsfläche 2 und/oder bei Berührung der Betätigungsfläche 2 mittels des Elements 3 und/oder bei Druckeinwirkung mittels des Elements 3 auf die Betätigungsfläche 2 erzeugt der jeweilige Sensor 4, 7 ein jeweiliges Signal. Dieses jeweilige Signal dient wiederum zum Schalten und/oder Auslösen einer dem jeweiligen Sensor 4, 7 zugeordneten Funktion in der Art eines Schalt- und/oder Steuersignals. Beispielsweise kann das mittels des kapazitiven Sensors 7 erzeugte Signal die Sitzheizung eines der Sitze im Kraftfahrzeug anwählen. Der jeweilige Sitz lässt sich dabei mittels eines Abschnittes 20, 20' im ersten Bereich 16 an der Betätigungsfläche 2 auswählen. Das weitere mittels des optischen Sensors 4 am zweiten Bereich 15 der Betätigungsfläche 2 erzeugte Signal kann zur Einstellung der Temperatur der jeweiligen Sitzheizung dienen. Es ist somit ein kapazitives Schaltbedienfeld 1 mit einem in die Betätigungsfläche 2 integrierten optischen Fingernavigationssensor geschaffen.

Wie weiter in Fig. 2 gezeigt ist, weist der kapazitive Sensor 7 eine elektrisch leitfähige Folie auf. Die elektrisch leitfähige Folie 7 ist an der Betätigungsfläche 2, und zwar an deren Unterseite, angeordnet. Selbstverständlich kann die elektrisch leitfähige Folie 7 auch in der Betätigungsfläche 2 angeordnet sein, beispielsweise in die Betätigungsfläche 2 eingebettet sein. Durch Anlegen einer elektrischen Spannung an die elektrisch leitfähige Folie 7 ist ein elektrisches Feld im Bereich der Betätigungsfläche 2 erzeugbar. Die durch die Einwirkung des Elements 3 auf die Betätigungsfläche 2 hervorgerufene Veränderung des elektrischen Feldes, und zwar insbesondere dessen kapazitive Veränderung, wird dann zur Erzeugung des Signals ausgewertet.

Wie weiter in Fig. 5 zu sehen ist, umfasst der optische Sensor 4 einen optischen Sender 8 und wenigstens einen optischen Empfänger 9 für die optische elektromagnetische Strahlung 5. Als optischer Sender 8 kann eine Leuchtdiode, eine IR(Infrarot)-Diode, eine Laserdiode o. dgl. verwendet werden. Als optischer Empfänger 9 kann eine Fotodiode Verwendung finden. Ein solchermaßen ausgebildeter optischer Sensor 4 arbeitet dann reflexionsoptisch zur Erzeugung des Signals.

Wie näher aus Fig. 2 hervorgeht, weist das Schaltbedienfeld 1 ein aus Kunststoff bestehendes Gehäuse 10 zur Aufnahme der Betätigungsfläche 2 auf. Und zwar bildet die Betätigungsfläche 2 eine im Wesentlichen geschlossene Oberfläche am Gehäuse 10. Die Betätigungsfläche 2 ist Bestandteil einer aus Kunststoff bestehenden Blende 11 in der Art einer Sichtblende. Der optische Sensor 4 sowie die Linse 6 sind der Blende 11 zugewandt im Gehäuse 10 angeordnet, und zwar sind diese im Wesentlichen direkt unterhalb der geschlossenen und/oder individuell im Design als Sichtblende gestalteten Blende 11 angebracht. Zweckmäßigerweise ist die elektrisch leitfähige Folie 7 durch Kleben an der Blende 11, durch Umspritzen und/oder Hinterspritzen der Folie 7 mittels Kunststoff bei Herstellung der Blende 11 o. dgl. befestigt, und zwar an der dem Inneren des Gehäuses 10 zugewandten Seite der Blende 11. Schließlich ist die Blende 11 mittels eines mechanischen Hubs 12 bewegbar am Gehäuse 10 angeordnet, so dass das Schaltbedienfeld 1 analog zur herkömmlichen Betätigung eines elektrischen Schalters bedienbar ist.

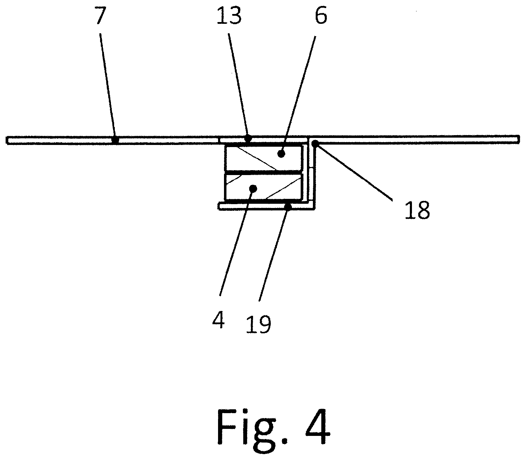

Die Blende 11 ist gemäß Fig. 5 für die optische elektromagnetische Strahlung 5 im Wesentlichen transparent. Je nach Art und/oder Wellenlänge der elektromagnetischen Strahlung 5 kann dann falls gewünscht gleichzeitig die Blende 11 für das menschliche Auge undurchsichtig sein. In bevorzugter Weise handelt es sich bei der optischen elektromagnetischen Strahlung 5 um Infrarotstrahlung, wobei dann die Blende 11 für Infrarotstrahlung im Wesentlichen durchlässig sowie für optische elektromagnetische Strahlung in dem für das menschliche Auge sichtbaren Spektrum im Wesentlichen undurchlässig ausgestaltet ist. Damit die optische Strahlung 5 insoweit nicht behindert wird, besitzt die elektrisch leitfähige Folie 7 im Bereich des optischen Sensors 4 eine Aussparung 13 und/oder eine Freisparung 13, wie in Fig. 4 gezeigt ist. Selbstverständlich kann die elektrisch leitfähige Folie 7 in diesem Bereich auch für die optische elektromagnetische Strahlung 5 im Wesentlichen transparent ausgebildet sein.

Der Sensor 4 sowie die Linse 6 sind der Blende 11 zugewandt im Gehäuse 10 angeordnet, wie in Fig. 2 zu sehen ist, und zwar ist die Linse 6 zwischen dem Sensor 4 und der Blende 11 angeordnet. Hierzu sind der Sensor 4 sowie die Linse 6 an einem Träger 14 angeordnet. Falls gewünscht, kann der optische Sensor 4 auch auf eine Leiterplatte, auf ein MID(Molded Interconnected Device)-Bauteil o. dgl. gelötet sein, was jedoch nicht weiter gezeigt ist. Die Leiterplatte, das MID-Bauteil, der Träger 14 o. dgl. sind im Gehäuse 10 befindlich. Zwecks einfacher Handhabung bei der Montage können der ansonsten separate optische Sensor 4 und die separate Linse 6 als ein Verbund-Bauteil ausgestaltet sein.

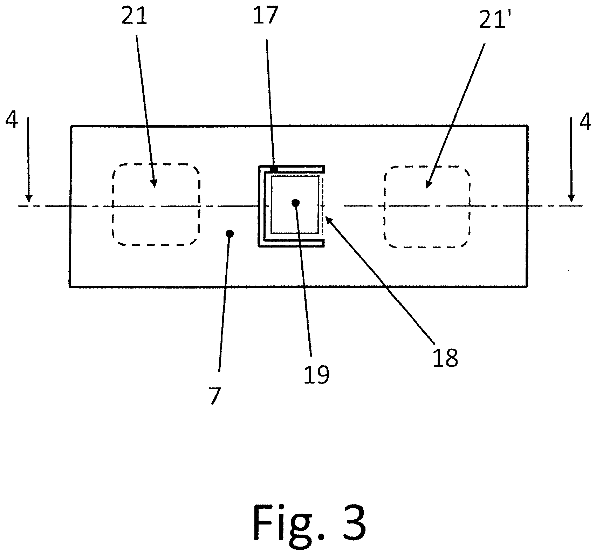

In besonders kompakter Ausgestaltung ist der optische Sensor 4 auf die kapazitiv wirkende, elektrisch leitfähige Folie 7 gelötet, wie näher in Fig. 3 und Fig. 4 zu sehen ist. Hierfür weist die kapazitive Folie 7 einen in etwa U-förmigen Einschnitt 17 auf. Der mittels des Einschnitts 17 freigeschnittene Teil der Folie 7 ist an einer Biegelinie 18 nach unten abgeknickt, derart dass ein absatzförmiger Bereich 19 an der kapazitiven Folie 7 ausgebildet ist. Der optische Sensor 4 ist am absatzförmigen Bereich 19 an der kapazitiven Folie 7 befestigt, und zwar auf die kapazitive Folie 7 aufgelötet. Die Höhe des absatzförmigen Bereichs 19 ist so gewählt, dass der optische Sensor 4 sowie die an dem optischen Sensor 4 angeordnete Linse 6 vom absatzförmigen Bereich 19 aufgenommen sind. Weiter ist der absatzförmige Bereich 19 mittels eines Trägerbauteils 14 im Gehäuse 10 abgestützt ist, wie in Fig. 2 gezeigt ist. Somit sind der Sensor 4 und die Linse 6 auch an dem im Gehäuse 10 befindlichen Trägerbauteil 14 zur Unterstützung und/oder Befestigung angeordnet.

Schließlich weist die kapazitive Folie 7 wenigstens einen als ein Bedienschaltelement wirkenden, dem Abschnitt 20, 20' zugeordneten Flächenbereich 21, 21' auf, wie anhand von Fig. 1 und Fig. 3 zu erkennen ist. Mittels des Elements 3 ist der Flächenbereich 21, 21' am Abschnitt 20, 20' der Betätigungsfläche 2 in der Art eines Push-Push-Schalters bedienbar. Der optische Sensor 4 arbeitet als ein in mehrere Richtungen sensitives Schaltelement, das mittels des Elements 3 am Bereich 15 der Betätigungsfläche 2 in der Art eines Navigationssensors bedienbar ist.

Die Erfindung ist nicht auf die beschriebenen und dargestellten Ausführungsbeispiele beschränkt. Sie umfasst vielmehr auch alle fachmännischen Weiterbildungen im Rahmen der durch die Patentansprüche definierten Erfindung. So kann das erfindungsgemäße Schaltbedienfeld nicht nur in Bedienfeldern für Kraftfahrzeuge sondern auch in Bedienfeldern an Hausgeräten, Audiogeräten, Videogeräten, Telekommunikationsgeräten o. dgl., und zwar insbesondere für Bedienfelder mit einem Sensor zur Fingernavigation, Verwendung finden.

### Bezugszeichen-Liste:

- 1:: Schaltbedienfeld
- 2:: Betätigungsfläche
- 3:: Element
- 4:: (optischer) Sensor
- 5:: (optische) Strahlung
- 5':: emittierte (ausgesandte) Strahlung
- 5":: reflektierte (empfangene) Strahlung
- 6:: Linse
- 7:: (kapazitiver) Sensor / elektrisch leitfähige Folie
- 8:: (optischer) Sender
- 9:: (optischer) Empfänger
- 10:: Gehäuse
- 11:: Blende
- 12:: Hub (für Blende)
- 13:: Aussparung / Freisparung (in leitfähiger Folie)
- 14:: Träger / Trägerbauteil
- 15,16:: Bereich (der Betätigungsfläche)
- 17:: U-förmiger Einschnitt (in der Folie)
- 18:: Biegelinie
- 19:: absatzförmiger Bereich
- 20,20':: Abschnitt (an Betätigungsfläche)
- 21,21':: Flächenbereich (an Folie)

## Patentansprüche

1. Schaltbedienfeld, insbesondere für ein Kraftfahrzeug,
mit einer Betätigungsfläche (2) zur manuellen Einwirkung mittels eines Elements (3),
wobei es sich insbesondere bei dem Element (3) um den Finger einer menschlichen Hand handelt,
mit einem Gehäuse (10) zur Aufnahme der Betätigungsfläche (2)
mit zwei mit der Betätigungsfläche (2) derart zusammenwirkenden Sensoren (4, 7), dass der jeweilige Sensor (4, 7) bei Annäherung des Elements (3) an die Betätigungsfläche (2) und/oder bei Berührung der Betätigungsfläche (2) mittels des Elements (3) und/oder bei Druckeinwirkung mittels des Elements (3) auf die Betätigungsfläche (2) ein Signal erzeugt, wobei das Signal zum Schalten und/oder Auslösen einer dem jeweiligen Sensor (4, 7) zugeordneten Funktion in der Art eines Schalt- und/oder Steuersignals dient,
wobei es sich bei dem ersten Sensor (7) um einen kapazitiv arbeitenden Sensor und bei dem zweiten Sensor (4) um einen mit optischer elektromagnetischer Strahlung (5) arbeitenden Sensor handelt,
wobei der optische Sensor (4) mit einer Linse (6) zusammenwirkt, derart dass die vom Sensor (4) ausgesandte Strahlung (5') und/oder die vom Sensor (4) empfangene Strahlung (5") zum und/oder vom Element (3) fokussiert, ist
**dadurch gekennzeichnet, dass**
der kapazitive Sensor (7) eine elektrisch leitfähige Folie aufweist,
wobei die elektrisch leitfähige Folie (7) in und/oder an der Betätigungsfläche (2) angeordnet ist,
derart dass durch Anlegen einer elektrischen Spannung ein elektrisches Feld im Bereich der Betätigungsfläche (2) erzeugbar ist, und dass die durch die Einwirkung des Elements (3) auf die Betätigungsfläche (2) hervorgerufene kapazitive Veränderung des elektrischen Feldes zur Erzeugung des Signals auswertbar ist
wobei die Betätigungsfläche (2) Bestandteil einer Blende (11), insbesondere in der Art einer Sichtblende, ist,
wobei die Blende (11) bewegbar am Gehäuse (10) angeordnet ist
wobei die elektrisch leitfähige Folie (7) an der dem Inneren des Gehäuses (10) zugewandten Seite der Blende (11) befestigt ist und
wobei der optische Sensor (4) auf die kapazitive Folie (7) gelötet ist.

2. Schaltbedienfeld nach Anspruch 1,
**dadurch gekennzeichnet, dass**
der optische Sensor (4) einen optischen Sender (8),
insbesondere eine Leuchtdiode, eine IR(Infrarot)-Diode, eine Laserdiode o. dgl., und
wenigstens einen optischen Empfänger (9),
insbesondere eine Fotodiode,
für die optische elektromagnetische Strahlung (5)
umfasst,
derart dass der optische Sensor (4) reflexionsoptisch zur Erzeugung des Signals arbeitet.

3. Schaltbedienfeld nach einem der Ansprüche 1 oder 2,
**dadurch gekennzeichnet, dass**
die Betätigungsfläche (2) eine im Wesentlichen geschlossene Oberfläche am Gehäuse (10) bildet.

4. Schaltbedienfeld nach einem der Ansprüche 1 bis 3,
**dadurch gekennzeichnet, dass**
die elektrisch leitfähige Folie (7) durch Kleben an der Blende (11), durch Umspritzen und/oder Hinterspritzen mittels der Blende (11) o. dgl. an der dem Inneren des Gehäuses (10) zugewandten Seite der Blende (11) befestigt ist.

5. Schaltbedienfeld nach einem der Ansprüche 1 bis 4,
**dadurch gekennzeichnet, dass**
die Blende (11) für die optische elektromagnetische Strahlung (5) im Wesentlichen transparent ist,
dass vorzugsweise die elektrisch leitfähige Folie (7) im Bereich des optischen Sensors (4) eine Aussparung (13) und/oder eine Freisparung (13) besitzt und/oder für die optische elektromagnetische Strahlung (5) im Wesentlichen transparent ist.

6. Schaltbedienfeld nach einem der Ansprüche 1 bis 5,
**dadurch gekennzeichnet, dass**
es sich bei der optischen elektromagnetischen Strahlung (5) um Infrarotstrahlung handelt, und
dass die Blende (11) für Infrarotstrahlung im Wesentlichen durchlässig sowie für optische elektromagnetische Strahlung in dem für das menschliche Auge sichtbaren Spektrum im Wesentlichen undurchlässig ist.

7. Schaltbedienfeld nach einem der Ansprüche 1 bis 6,
**dadurch gekennzeichnet, dass**
der Sensor (4) sowie die Linse (6) der Blende (11) zugewandt im Gehäuse (10) angeordnet sind,
wobei die Linse (6) zwischen dem Sensor (4) und der Blende (11) angeordnet ist, und dass vorzugsweise der Sensor (4) und die Linse (6) als ein Verbund-Bauteil ausgestaltet sind.

8. Schaltbedienfeld nach einem der Ansprüche 1 bis 7,
**dadurch gekennzeichnet, dass**
der optische Sensor (4) sowie die Linse (6) an einem Träger (14) angeordnet sind und dass der Träger (14) im Gehäuse (10) befindlich ist.

9. Schaltbedienfeld nach einem der Ansprüche 1 bis 8,
**dadurch gekennzeichnet, dass**
die elektrisch leitfähige Folie (7) einen in etwa U-förmigen Einschnitt (17) aufweist,
derart dass ein absatzförmiger Bereich (19) an der kapazitiven Folie (7) ausgebildet ist,
dass der optische Sensor (4) am absatzförmigen Bereich (19) an der elektrisch leitfähigen Folie (7) befestigt ist und
dass vorzugsweise der absatzförmige Bereich (19) mittels eines Trägerbauteils (14) im Gehäuse (10) abgestützt ist.

10. Schaltbedienfeld nach einem der Ansprüche 1 bis 9,
**dadurch gekennzeichnet, dass**
die elektrisch leitfähige Folie (7) wenigstens einen als ein Bedienschaltelement wirkenden Flächenbereich (21, 21') aufweist.

## Claims

1. A switch control panel, in particular for an automotive vehicle,
having an actuation face (2) for manual action by means of an element (3), wherein, in particular, the element (3) is the finger of a human hand,
having a housing (10) for receiving the actuation face (2),
having two sensors (4, 7) cooperating with the actuation face (2) such that the respective sensor (4, 7) generates a signal upon the element (3) approaching the actuation face (2) and/or upon contacting the actuation face (2) by means of the element (3) and/or upon pressure action onto the actuation face (2) by means of the element (3), wherein the signal is for switching and/or triggering a function associated with the respective sensor (4, 7) in the manner of a switching and/or control signal,
wherein the first sensor (7) is a capacitively operating sensor, and the second sensor (4) is a sensor operating with optical electromagnetic radiation (5),
wherein the optical sensor (4) cooperates with a lens (6) such that the radiation (5') emitted by the sensor (4) and/or the radiation (5") received by the sensor (4) is focused towards and/or away from the element (3),
**characterized in that** the capacitive sensor (7) has an electrically conductive film, wherein the electrically conductive film (7) is arranged in and/or on the actuation face (2),
such that by applying an electric voltage, an electric field is generatable in the region of the actuation face (2), and that the capacitive change in the electric field caused by the action of the element (3) onto the actuation face (2) for generating the signal is evaluable,
wherein the actuation face (2) is a constituent part of a cover (11), in particular in the manner of a trim cover,
wherein the cover (11) is movably arranged on the housing (10),
wherein the electrically conductive film (7) is fastened to the side of the cover (11) facing the interior of the housing (10), and
wherein the optical sensor (4) is soldered to the capacitive film (7).

2. The switch control panel of claim 1, **characterized in that** the optical sensor (4) comprises an optical transmitter (8), in particular a light-emitting diode, an IR (infrared) diode, a laser diode, or the like, and at least one optical receiver (9), in particular a photodiode, for the optical electromagnetic radiation (5), such that the optical sensor (4) operates in a reflection-optical fashion for generating the signal.

3. The switch control panel of any one of claims 1 or 2, **characterized in that** the actuation face (2) forms a substantially closed surface on the housing (10).

4. The switch control panel of any one of claims 1 to 3, **characterized in that** the electrically conductive film (7) is fastened to the side of the cover (11) facing the interior of the housing (10) by adhesive bonding to the cover (11), by overmolding and/or back-injection molding by means of the cover (11), or the like.

5. The switch control panel of any one of claims 1 to 4, **characterized**
**in that** the cover (11) is substantially transparent to the optical electromagnetic radiation (5),
**in that** preferably, the electrically conductive film (7) possesses a recess (13) and/or a clearance (13) in the region of the optical sensor (4) and/or is substantially transparent to the optical electromagnetic radiation (5).

6. The switch control panel of any one of claims 1 to 5, **characterized**
**in that** the optical electromagnetic radiation (5) is infrared radiation, and
**in that** the cover (11) is substantially permeable to infrared radiation as well as substantially impermeable to optical electromagnetic radiation in the spectrum visible to the human eye.

7. The switch control panel of any one of claims 1 to 6, **characterized in that** the sensor (4) as well as the lens (6) are arranged in the housing (10) facing the cover (11),
wherein the lens (6) is arranged between the sensor (4) and the cover (11), and
**in that** preferably, the sensor (4) and the lens (6) are designed as a composite component.

8. The switch control panel of any one of claims 1 to 7, **characterized in that** the optical sensor (4) as well as the lens (6) are arranged on a carrier (14), and **in that** the carrier (14) is located in the housing (10).

9. The switch control panel of any one of claims 1 to 8, **characterized**
**in that** the electrically conductive film (7) has an approximately U-shaped notch (17), such that a shoulder-shaped region (19) is formed on the capacitive film (7),
**in that** the optical sensor (4) is fastened to the electrically conductive film (7) in the shoulder-shaped region (19), and
**in that** preferably, the shoulder-shaped region (19) is supported in the housing (10) by means of a carrier component (14).

10. The switch control panel of any one of claims 1 to 9, **characterized in that** the electrically conductive film (7) has at least one face region (21, 21') acting as a control switching element.

## Revendications

1. Panneau de commande de commutation, en particulier pour un véhicule automobile, comprenant
une surface d'actionnement (2) pour une action manuelle au moyen d'un élément (3), l'élément (3) étant en particulier le doigt d'une main humaine,
un boîtier (10) pour recevoir la surface d'actionnement (2),
deux capteurs (4, 7) coopérant avec la surface d'actionnement (2) de telle sorte que le capteur respectif (4, 7) génère un signal lorsque l'élément (3) est rapproché de la surface d'actionnement (2) et/ou en cas de contact avec la surface d'actionnement (2) au moyen de l'élément (3) et/ou sous l'action d'une pression au moyen de l'élément (3) sur la surface d'actionnement (2), le signal servant à commuter et/ou à déclencher une fonction attribuée au capteur respectif (4, 7) à la manière d'un signal de commutation et/ou de commande,
dans lequel le premier capteur (7) est un capteur à fonctionnement capacitif et le deuxième capteur (4) est un capteur fonctionnant avec un rayonnement électromagnétique optique (5),
dans lequel le capteur optique (4) coopère avec une lentille (6) de telle sorte que le rayonnement (5') émis par le capteur (4) et/ou le rayonnement (5") reçu par le capteur (4) est focalisé en direction et/ou en provenance de l'élément (3),
**caractérisé en ce que** le capteur capacitif (7) présente un film électriquement conducteur,
dans lequel le film électriquement conducteur (7) est disposé dans et/ou sur la surface d'actionnement (2),
de telle sorte que l'application d'une tension électrique permet de générer un champ électrique au niveau de la surface d'actionnement (2), et que le changement capacitif du champ électrique, provoqué par l'action de l'élément (3) sur la surface d'actionnement (2), peut être évalué pour générer le signal,
dans lequel la surface d'actionnement (2) fait partie d'un cadre (11), en particulier à la manière d'un cache,
dans lequel le cadre (11) est disposé de manière mobile sur le boîtier (10),
dans lequel le film électriquement conducteur (7) est fixé au côté du cadre (11) tourné vers l'intérieur du boîtier (10), et
dans lequel le capteur optique (4) est brasé sur le film capacitif (7).

2. Panneau de commande de commutation selon la revendication 1, **caractérisé en ce que** le capteur optique (4) comprend un émetteur optique (8), en particulier une diode électroluminescente, une diode IR (infrarouge), une diode laser ou similaires, et au moins un récepteur optique (9), en particulier une photodiode, pour le rayonnement électromagnétique optique (5), de telle sorte que le capteur optique (4) fonctionne de manière optique à réflexion pour générer le signal.

3. Panneau de commande de commutation selon l'une quelconque des revendications 1 ou 2, **caractérisé en ce que** la surface d'actionnement (2) constitue une surface substantiellement fermée au niveau du boîtier (10).

4. Panneau de commande de commutation selon l'une quelconque des revendications 1 à 3, **caractérisé en ce que** le film électriquement conducteur (7) est fixé au cadre (11) par collage, par surmoulage et/ou par injection arrière au moyen du cadre (11) ou similaires sur le côté du cadre (11) tourné vers l'intérieur du boîtier (10).

5. Panneau de commande de commutation selon l'une quelconque des revendications 1 à 4, **caractérisé**
**en ce que** le cadre (11) est substantiellement transparent au rayonnement électromagnétique optique (5).
**en ce que** de préférence le film électriquement conducteur (7) dispose au niveau du capteur optique (4) d'un évidement (13) et/ou d'un dégagement (13) et/ou est substantiellement transparent au rayonnement électromagnétique optique (5).

6. Panneau de commande de commutation selon l'une quelconque des revendications 1 à 5, **caractérisé**
**en ce que** le rayonnement électromagnétique optique (5) est un rayonnement infrarouge, et
**en ce que** le cadre (11) laisse substantiellement passer le rayonnement infrarouge et ne laisse substantiellement pas passer le rayonnement électromagnétique optique dans le spectre visible pour l'œil humain.

7. Panneau de commande de commutation selon l'une quelconque des revendications 1 à 6, **caractérisé en ce que** le capteur (4) ainsi que la lentille (6) sont disposés dans le boîtier (10) en étant tournés vers le cadre (11),
dans lequel la lentille (6) est disposée entre le capteur (4) et le cadre (11), et **en ce que** de préférence le capteur (4) et la lentille (6) sont configurés sous forme de composant composite.

8. Panneau de commande de commutation selon l'une quelconque des revendications 1 à 7, **caractérisé en ce que** le capteur optique (4) ainsi que la lentille (6) sont disposés sur un support (14), et **en ce que** le support (14) se trouve dans le boîtier (10).

9. Panneau de commande de commutation selon l'une quelconque des revendications 1 à 8, **caractérisé**
**en ce que** le film électriquement conducteur (7) présente une incision (17) approximativement en forme de U de telle sorte qu'une zone en forme d'épaulement (19) est réalisée au niveau du film capacitif (7),
**en ce que** le capteur optique (4) est fixé au film électriquement conducteur (7) au niveau de la zone en forme d'épaulement (19), et
**en ce que** de préférence la zone en forme d'épaulement (19) est supportée au moyen d'un composant de support (14) dans le boîtier (10).

10. Panneau de commande de commutation selon l'une quelconque des revendications 1 à 9, **caractérisé en ce que** le film électriquement conducteur (7) présente au moins une zone de surface (21, 21') agissant comme un élément de commutation de commande.
